(19) Europäisches Patentamt
European Patent Office
Office européen des brevets

(11) **EP 4 712 713 A1**

(12) **EUROPEAN PATENT APPLICATION**
published in accordance with Art. 153(4) EPC

(43) Date of publication:
**18.03.2026 Bulletin 2026/12**

(21) Application number: **24807154.0**

(22) Date of filing: **10.05.2024**

(51) International Patent Classification (IPC):
*H05K 9/00* (2006.01)    *B29C 43/18* (2006.01)
*B32B 5/28* (2006.01)    *H01M 50/224* (2021.01)
*H01M 50/231* (2021.01)    *H01M 50/249* (2021.01)

(52) Cooperative Patent Classification (CPC):
Y02E 60/10

(86) International application number:
**PCT/JP2024/017434**

(87) International publication number:
**WO 2024/237202 (21.11.2024 Gazette 2024/47)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **12.05.2023 JP 2023079116**

(71) Applicant: **Teijin Limited**
**Osaka-shi, Osaka 530-0005 (JP)**

(72) Inventors:
• **SUZUKI Shuhei**
**Osaka-shi, Osaka 530-0005 (JP)**
• **YOKOMIZO Hodaka**
**Osaka-shi, Osaka 530-0005 (JP)**
• **MAEDA Toshiki**
**Osaka-shi, Osaka 530-0005 (JP)**

(74) Representative: **Hoffmann Eitle**
**Patent- und Rechtsanwälte PartmbB**
**Arabellastraße 30**
**81925 München (DE)**

(54) **INTEGRALLY MOLDED BODY OF FIBER-REINFORCED RESIN LAYER AND BLOCKING LAYER, AND METHOD FOR MANUFACTURING THE SAME**

(57) Provided is an integrally molded body that has a blocking layer for cutting off radio waves and magnetic waves. This integrally molded body comprises a fiber-reinforced resin layer containing reinforcing fibers and a first matrix resin, and a blocking layer, wherein the blocking layer contains an aggregate of metal strips and a second matrix resin, and blocks at least one of an electric field or a magnetic field, the metal strips being dispersed in the surface of the blocking layer to form the aggregate.

**FIG. 1**

EP 4 712 713 A1

**Description**

TECHNICAL FIELD

The present invention relates to an integrally molded article of a fiber-reinforced resin layer and a shielding layer and a production method thereof.

BACKGROUND ART

Various techniques for shielding against an electric field using a metal and a resin have been studied.

PTL 1 describes a resin molded article containing thin metal foil pieces in which thin pieces of a laminate of a metal foil and a plastic film are randomly bonded to each other and dispersed.

PTL 2 describes a method for molding an electromagnetic shielding resin outer plate in which unevenness is formed in a mold for molding the back surface of an outer plate and which includes stacking an aluminum foil and an SMC (sheet molding compound), setting in the mold and joining the aluminum foil to a resin by heating and pressurizing molding.

PTL 3 provides a vehicle structure having an electromagnetic wave-shielding effect while simplifying the production step by providing a portion where an electromagnetic wave-shielding layer does not follow a component of a battery box having a recess.

PTL 4 describes an electromagnetic wave-shielding material in which elastic fibers are partially melted and solidified by integrally molding at least two elastic body layers made of resin elastic fibers and a granular or flaky magnetic material shielding layer sandwiched between the elastic body layers and in which the magnetic material is entangled with the elastic fibers and held in a semi-floating state. In the electromagnetic wave-shielding material described in PTL 4, each particle or flake can move freely to some extent, and even when the shielding material is deformed by an external load or an impact, each particle or flake is not distorted, and the shielding property is not deteriorated.

The electromagnetic wave-shielding body described in PTL 5 can be formed into an electromagnetic wave-shielding body having a high degree of processing such as a box shape through heat molding, and stable electromagnetic wave-shielding performance is maintained without causing destruction of the conductive composition layer during processing.

The invention described in PTL 6 discloses a composite material for shielding against electromagnetic waves in which a fiber-reinforced resin molded article portion containing carbon fibers and a matrix resin and a metal layer portion are laminated.

CITATION LIST

PATENT LITERATURE

PTL 1: JPS58-84856A

PTL 2: JPH04-110278A

PTL 3: WO2021/125386

PTL 4: JPH09-292480A

PTL 5: JPH06-021683A

PTL 6: JP2012-109454A

SUMMARY OF INVENTION

TECHNICAL PROBLEM

A vehicle structure is sometimes required to have a shielding property for blocking radio waves or magnetic waves.

However, in the resin molded article containing thin metal foil pieces described in PTL 1, since the thin metal pieces are simply mixed in the resin molded article, the property of shielding against radio waves or a magnetic field may be reduced. In general, the property of shielding against an electric field or a magnetic field increases as the conductivity of the material increases. In the resin molded article containing thin metal foil pieces described in PTL 1, since the thin metal pieces are covered with the resin, the thin metal pieces are not in contact with each other. Therefore, the conductivity of the resin molded article described in PTL 1 is not high, and the property of shielding against an electric field or a magnetic field is insufficient.

PTL 2 merely discloses a method for molding a simple shape such as a flat plate, although an attempt is made to shape the aluminum foil with unevenness. In the molding method described in PTL 2, when an integrally molded article having a top surface portion and a standing plane portion, such as a hat shape, is to be formed, the aluminum foil cannot be shaped to follow the resin.

In PTL 3, the electromagnetic wave-shielding layer is not caused to follow the component of the battery box having the recess. PTL 3 does not examine at all any technique for causing the shielding layer to follow when there is a recess or a deeply-drawn portion. In order to place the shielding layer so as to follow a molded article having a complicated shape, it is necessary to pre-shape the shielding layer and adhere the shielding layer to the molded article, which increases assembly man-hours. In addition, when simultaneous molding of a shielding layer precursor (flat plate) and a molding material is attempted without shaping in advance (pre-shaping) to suppress an increase in the man-hours, a problem arises because the shielding layer is displaced.

In the electromagnetic wave-shielding material described in PTL 4, the flaky magnetic material used for the shielding layer is too heavy. In addition, since only one of the two types of resins is melted to form the semi-floating state, the magnetic material is not fixed.

In the electromagnetic wave-shielding body described in PTL 5, since metal fibers are used, a gap is formed.

In the composite material for shielding against electromagnetic waves described in PTL 6, since a metal plate is used, the metal plate cannot follow when the metal plate is integrally molded into a molded article having a complicated shape.

SOLUTION TO PROBLEM

As a result of intensive studies, the present inventors have found that the problems can be solved by the following means. Thus, the invention has been completed.

1. An integrally molded article including a fiber-reinforced resin layer containing reinforcing fibers and a first matrix resin and a shielding layer

in which the shielding layer is a layer containing an aggregate of metal strips and a second matrix resin and shields against at least one of an electric field and a magnetic field and
in which the aggregate of the metal strips is formed of metal strips dispersed in the plane of the shielding layer.

2. The integrally molded article according to 1 above in which the integrally molded article has a top surface portion and a standing plane portion.

3. The integrally molded article according to any one of 1 and 2 above including a portion satisfying $2 \leq tx/ty$, when the thickness of the shielding layer is defined as tx, and the thickness of the metal strips is defined as ty.

4. The integrally molded article according to any one of 1 to 3 above in which the mass proportion W (metal) of the aggregate of the metal strips in the shielding layer is 30% or more.

5. The integrally molded article according to any one of 1 to 4 above in which the metal strips have a width of 1 mm or more and 40 mm or less, a length of 1 mm or more and 100 mm or less, and a thickness of 100 $\mu$m or less.

6. The integrally molded article according to any one of 1 to 5 above in which the reinforcing fibers are discontinuous fibers and are dispersed in the in-plane direction of the fiber-reinforced resin layer.

7. The integrally molded article according to any one of 1 to 6 above in which the shielding layer has a property of shielding against an electric field or a magnetic field of 10 decibels or more in at least a part of a region of more than 0 MHz and 3000 MHz or less.

8. The integrally molded article according to any one of 1 to 6 above in which the shielding layer has a property of shielding against an electric field or a magnetic field of 10 decibels or more in at least a part of a region of more than 0 MHz and 100 MHz or less.

9. The integrally molded article according to 2 above in which the thickness ta of the standing plane portion and the thickness tb of the top surface portion satisfy $ta \leq tb$.

10. The integrally molded article according to 9 above in which the integrally molded article satisfies $txa \leq txb$ and $ta - txa \geq tb - txb$,

when the thickness of the shielding layer in the standing plane portion is defined as txa, and the thickness of the fiber-reinforced resin layer is defined as ta - txa, the thickness of the shielding layer in the top surface portion is defined as txb, and the thickness of the fiber-reinforced resin layer is defined as tb - txb.

11. A vehicle structure having the integrally molded article according to any one of 1 to 10 above.

12. A component of a battery box having the integrally molded article according to any one of 1 to 10 above, wherein the component of the battery box is placed at a lower portion of a vehicle body.

13. A method for producing the integrally molded article according to any one of 1 to 10 above including stacking the fiber-reinforced resin containing the reinforcing fibers and the first matrix resin and the shielding layer precursor and performing press-molding with an upper mold and a lower mold.

14. The method for producing the integrally molded article according to 13 above, in which the fiber-reinforced resin and the shielding layer precursor are laminated in such a manner that the fiber-reinforced resin is in contact with a lower mold, and the laminate is placed in the lower mold and subjected to the press-molding.

15. The method for producing the integrally molded article according to any one of 13 and 14 above in which a relationship between a ductility E1 of the fiber-reinforced resin and a ductility E2 of the laminate of the fiber-reinforced resin and the shielding layer precursor satisfies $0.9 < E1/E2 < 50$.

16. The method for producing the integrally molded article according to any one of 13 to 15 above in which the first matrix resin and the second matrix resin are thermoplastic resins.

ADVANTAGEOUS EFFECTS OF INVENTION

Using an aggregate of metal strips, integral molding with a fiber-reinforced resin layer having a complicated three-dimensional shape is enabled, and the step of pre-shaping the metal shielding layer and adhering to the fiber-reinforced resin layer can be simplified.

BRIEF DESCRIPTION OF DRAWINGS

FIG. 1 is a schematic cross-sectional view of an integrally molded article.

FIG. 2A illustrates a state in which a metal plate alone is shaped using molds. Before the upper mold is closed.

FIG. 2B illustrates a state in which the upper mold is closed and the metal plate is pressed.

FIG. 3 is a plan view of an example of the shielding layer precursor 20.

FIG. 4 is a photograph showing a state in which some of the metal strips are laid sideways.

FIG. 5A shows evaluation of the electric field-shielding performance of a polypropylene resin layer having a thickness of 150 $\mu$m.

FIG. 5B shows evaluation of the electric field-shielding performance of a shielding layer having a thickness of 150 $\mu$m containing an aluminum thin film and a polypropylene resin in which the mass proportion W of the aluminum thin film is 25%.

FIG. 5C shows evaluation of the electric field-shielding performance of a shielding layer having a thickness of 150 $\mu$m containing an aluminum thin film and a polypropylene resin in which the mass proportion W of the aluminum thin film is 45%.

FIG. 5D shows evaluation of the electric field-shielding performance of a shielding layer having a thickness of 150 $\mu$m containing an aluminum thin film and a polypropylene resin in which the mass proportion W of the aluminum thin film is 65%.

FIG. 5E shows evaluation of the electric field-shielding performance of a shielding layer having a thickness of 150 $\mu$m containing an aluminum thin film and a polypropylene resin in which the mass proportion W of the metal (aluminum) thin film is 75%.

FIG. 5F shows evaluation of the electric field-shielding performance of an aluminum thin film having a thickness of 150 $\mu$m.

FIG. 6 is a schematic view in which metal strips are slit by pressing against a lower support roller.

FIG. 7 is a schematic side view in which metal strips are slit by the shear blade method.

FIG. 8 is a cross-sectional view taken along the line VIII-VIII in FIG. 7.

FIG. 9 is an enlarged view of the portion IX in FIG. 8.

FIG. 10 is a schematic view in which metal strips are slit by the gang method.

FIG. 11 is a cross-sectional view taken along the line XI-XI in FIG. 10.

FIG. 12 is an enlarged view of the portion XII in FIG. 11.

FIG. 13 is a cross-sectional view of an example of the integrally molded article 1A.

FIG. 14 is an exploded perspective view of an example of a battery box using an integrally molded article.

FIG. 15 is a perspective view of an example of a battery tray.

FIG. 16 is a cross-sectional view taken along XVI-XVI in FIG. 15.

FIG. 17A is a schematic view of the method for measuring a molding heating temperature.

FIG. 17B is a schematic view of the method for measuring ductility.

FIG. 17C is a schematic view of the method for measuring ductility.

DESCRIPTION OF EMBODIMENTS

Hereinafter, embodiments of the invention will be explained, but the invention is not restricted by the embodiments.

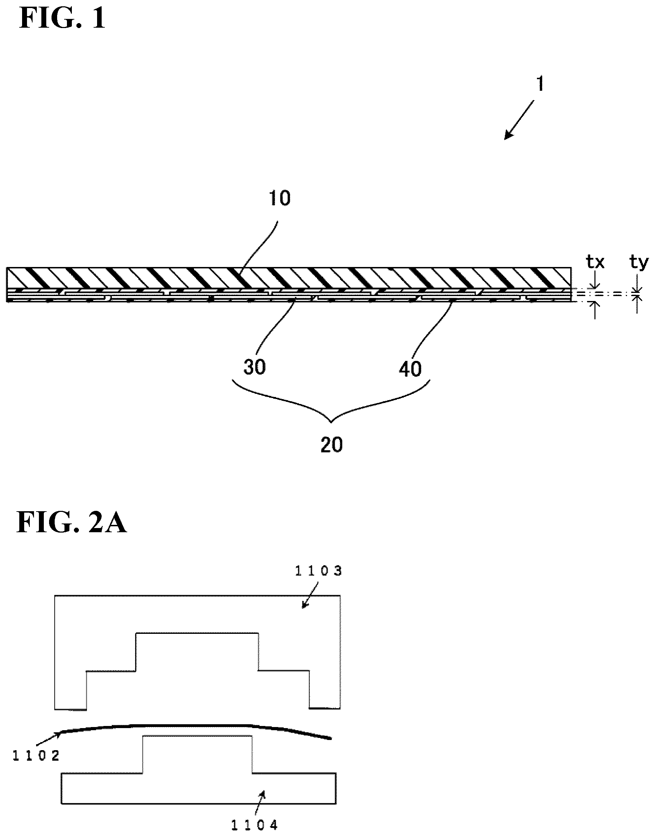

FIG. 1 is a schematic cross-sectional view of a laminate 1 for forming the integrally molded article according to an embodiment of the invention. The laminate 1 has a fiber-reinforced resin 10 and a shielding layer precursor 20.

[Shielding Layer Precursor]

As illustrated in FIG. 1, the shielding layer precursor 20 is a layer containing an aggregate of metal strips 30 and a second matrix resin 40. The aggregate of the metal strips 30 shields against at least one of an electric field and a magnetic field.
The metal strips 30 are dispersed inside the shielding layer precursor 20 and form an aggregate.

[Advantages in Molding Using Aggregate of Metal Strips]

1. Problems of Related Art

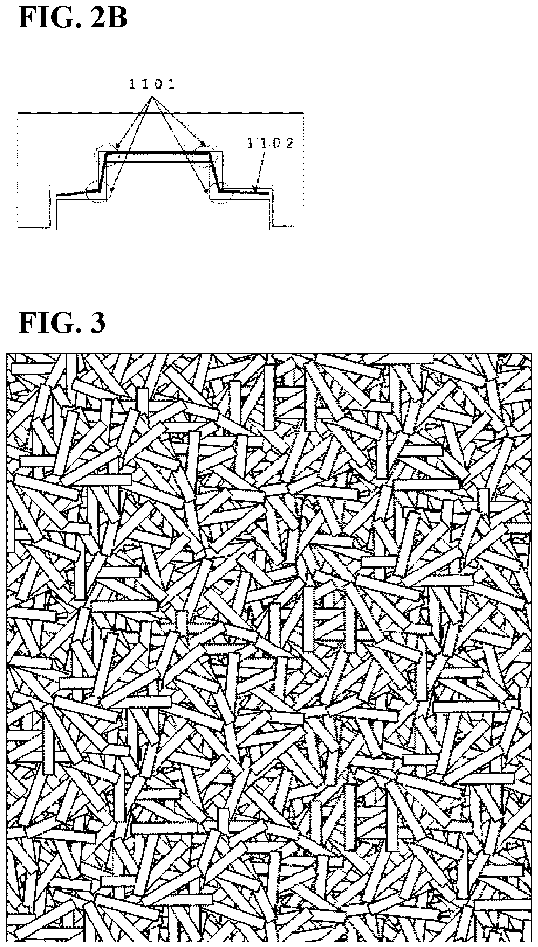

When a metal plate is shaped separately from a fiber-reinforced resin layer without using an aggregate of metal strips, in particular, the corners tend to be broken due to the unevenness of the mold. This is because the metal plate (for example, an aluminum foil) is elongated to the elongation at break thereof or more at the corners. Portions where the metal plate 1102 is easily broken are indicated with 1101 in FIG. 2B. When a metal plate alone is molded, it is necessary to provide gentle curves in the mold corners so that the metal plate is not broken due to the mold. As another method, in order to improve the yield, there has been a reinforcing method by putting a cushioning material/reinforcing material such as duct tape to prevent the breakage at the portions 1101 in FIG. 2B.
In addition, when not only the corners as in FIG. 2B but also a deeply-drawn portion is to be provided in the metal plate, the portion tends to wrinkle. Alternatively, as a design of the metal layer, a contrivance to reduce the sharpness of the corners has been required.

2. Effect of Aggregate of Metal Strips (i)

On the other hand, in the case of integrally molding using an aggregate of metal strips, the shielding layer precursor is not easily broken even when the corners of the mold hit, and it is not necessary to provide soft curves at the corners of the mold.

3. Effect of Aggregate of Metal Strips (ii)

In the case in which the resin contained in the fiber-reinforced resin is a thermoplastic resin and in which cold press molding is used, when the shielding layer precursor is placed in the lower mold and the fiber-reinforced resin is laminated in such a manner that the fiber-reinforced resin comes into contact with the upper mold, the fiber-reinforced resin is not cooled to the mold temperature until immediately before the fiber-reinforced resin comes into contact with the upper mold. Therefore, ribs and bosses are easily provided in the fiber-reinforced resin, and the design is also improved.

4. Effect of Aggregate of Metal Strips (iii)

Moreover, the shielding layer precursor 20 contains the second matrix resin 40. Since the second matrix resin is contained, when the fiber-reinforced resin 10 and the shielding layer precursor 20 are integrally molded, ribs, bosses, and the like are easily provided in the shielding layer. When a metal plate only is provided as a separate component as in the related art, the shielding layer cannot have a complicated shape.

5. Effect of Aggregate of Metal Strips (iv)

The shielding layer precursor 20 is preferably embedded in the integrally molded article, and the surface of the integrally molded article and the surface of the shielding layer are preferably at the same level. In this case, there is no step at the interface between the integrally molded article and the shielding layer, and a flat shape is obtained. The fitting interface may be the top surface portion of the integrally molded article or the standing plane portion. Since the edges of the shielding layer are filled with the resin during the integral molding, the breaks of the edges of the shielding layer can also be reduced.

[Shielding Layer: Metal Strips]

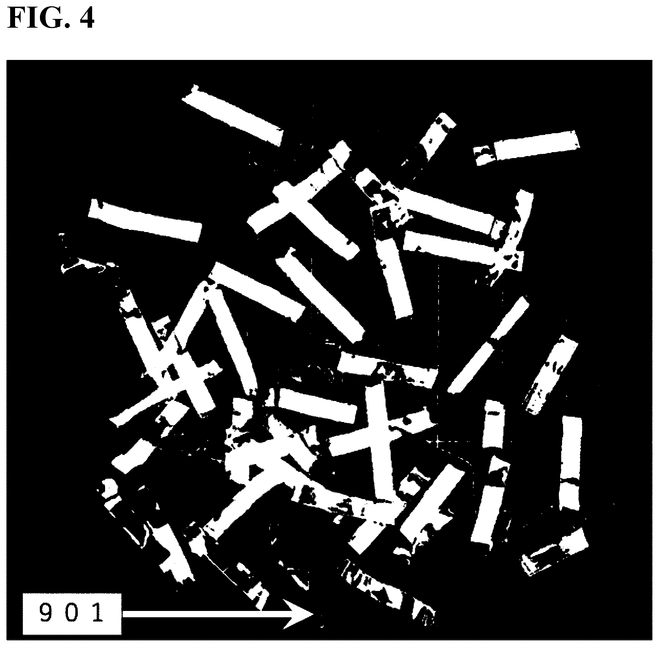

The metal strips preferably have a width of 1 mm or more and 40 mm or less, a length of 1 mm or more and 100 mm or less, and a thickness of 100 $\mu$m or less. When the width is 1 mm or more, slitting is facilitated. The metal strips more preferably have a width of 1 mm or more and 40 mm or less, a length of 1 mm or more and 40 mm or less, and a thickness of 100 $\mu$m or less.
The width of the metal strips is more preferably 2 mm or more and 20 mm or less, further preferably 2 mm or more and 7 mm or less, and still more preferably 2 mm or more and 5 mm or less.
The length of the metal strips is more preferably 2 mm or more and 20 mm or less, further preferably 2 mm or more and 7 mm or less, and still more preferably 2 mm or more and 5 mm or less.
The thickness of the metal strips is more preferably 70 $\mu$m or less, further preferably 50 $\mu$m or less, and still more preferably 30 $\mu$m or less. The lower limit of the thickness of the metal strips is preferably 12 $\mu$m or more, and more preferably 15 $\mu$ or more.
The metal strips may have a strip shape.
The weight of each metal strip is preferably 0.001 g or more and 0.050 g or less, more preferably 0.003 g or more and 0.040 g or less, and further preferably 0.005 g or more and 0.020 g or less. Specifically, when the metal strip has a width of 5 mm, a length of 20 mm, and a thickness of 30 $\mu$m, the weight is about 0.008 g.
When such light metal strips are sprayed, some of the metal strips stand without being laid sideways. Specifically, 1% or less of the metal strips stand among the metal thin film (for example, 901 in FIG. 4). Here, that a metal strip "stands" means that the thickness direction is oriented in the horizontal direction. The standing metal strips are crushed during integral molding.

[Shielding Layer: Mass Proportion W (metal) of Aggregate of Metal Strips]

The mass proportion W (metal) of the aggregate of the metal strips in the shielding layer is preferably 30% or more. The mass proportion is preferably 50% or more, and further preferably 70% or more. The mass proportion W (metal) of the aggregate of the metal strips is the mass proportion of the metal strips in the total mass including not only the metal strips and the second matrix resin but also other additives and the like.

In a method for measuring the mass proportion W (metal), when the second matrix resin contained in the shielding layer is a polypropylene resin, the shielding layer is burned in a furnace at 500°C for one hour to remove the resin, and the mass of the sample is measured before and after the treatment to calculate the mass of the shielding layer and the aggregate of the metal strips. Next, the volume fractions of the aggregate of the metal strips, the resin, and the other additives may be calculated using the specific gravities of the components.

Mass proportion W (metal) = 100 × mass of aggregate of metal strips/(mass of aggregate of metal strips + mass of resin + other additives)

[Shielding Layer: Random Dispersion in In-Plane Direction]

FIG. 3 is a plan view of an example of the shielding layer precursor 20. As illustrated in FIG. 3, the metal strips are dispersed in the in-plane direction of the shielding layer precursor 20. Here, that the metal strips are "dispersed in the in-plane direction" means that the metal strips are dispersed in a state in which the thickness directions of the metal strips are substantially the same as the thickness direction of the shielding layer and in which the length directions of the metal strips are in random directions in the plane of the shielding layer. In a region formed by press molding without flowing the shielding layer precursor 20, the state of the metal strips is substantially maintained during molding. Therefore, the metal strips included in the non-flowing region of the shielding layer precursor are also preferably dispersed in the in-plane direction and more preferably randomly dispersed. Randomly dispersed refers to a state in which the metal strips are not oriented in a specific direction such as one direction in the in-plane direction of the shielding layer precursor or the shielding layer but are oriented in a disordered manner and are placed in the plane without exhibiting a specific directivity as a whole. Here, even in a state in which some of the metal strips are laid sideways (a state in which the thickness directions of the metal strips are in the in-plane direction of the shielding layer) (for example, 901 in FIG. 4) during preparation of the aggregate of the metal strips, when the shielding layer precursor is press molded, the metal strips are dispersed in the in-plane direction in the shielding layer after molding.

[Shielding Layer: Shielding against Electric Field or Magnetic Field]

1. The shielding layer shields against at least one of an electric field and a magnetic field and preferably has a property of shielding against an electric field or a magnetic field of 10 decibels or more in at least a part of a region of more than 0 MHz and 3000 MHz or less. The property of shielding against an electric field or a magnetic field is more preferably 20 decibels or more, and further preferably 30 decibels or more. Here, the shielding property can be expressed with 10 times the common logarithm of the ratio of the power of the electromagnetic wave before passing through the shielding layer to the power of the electromagnetic wave after passing through the shielding layer (decibels).

As a preferable range per shielded region, the property of shielding against an electric field or a magnetic field is preferably 10 decibels or more in at least 50% of the region of more than 0 MHz and 3000 MHz or less. The property of shielding against an electric field or a magnetic field is more preferably 20 decibels or more, and further preferably 30 decibels or more. "In at least 50% of the region of more than 0 MHz and 3000 MHz or less" may refer to a continuous shielded region in the region of more than 0 MHz and 3000 MHz or less or a non-continuous shielded region.

As a preferable range per shielded region, the property of shielding against an electric field or a magnetic field is preferably 10 decibels or more in the entire region of more than 0 MHz and 3000 MHz or less. The property of shielding against an electric field or a magnetic field is more preferably 20 decibels or more, and further preferably 30 decibels or more.

2. Hereinafter, a more preferable shielding property will be explained.

The shielding layer shields against at least one of an electric field and a magnetic field and preferably has a property of shielding against an electric field or a magnetic field of 10 decibels or more in at least a part of a region of more than 0 MHz and 100 MHz or less. The property of shielding against an electric field or a magnetic field is more preferably 20 decibels or more, and further preferably 30 decibels or more.

As a preferable range per shielded region, the property of shielding against an electric field or a magnetic field is preferably 10 decibels or more in at least 50% of the region of more than 0 MHz and 100 MHz or less. The property of shielding against an electric field or a magnetic field is more preferably 20 decibels or more, and further preferably 30 decibels or more. "In at least 50% of the region of more than 0 MHz and 100 MHz" may refer to a continuous shielded region in the region of more than 0 MHz and 100 MHz or a non-continuous shielded region.

As a preferable range per shielded region, the property of shielding against an electric field or a magnetic field is preferably 10 decibels or more in the entire region of more than 0 MHz and 100 MHz or less. The property of shielding against an electric field or a magnetic field is more preferably 20 decibels or more, and further preferably 30 decibels or more.

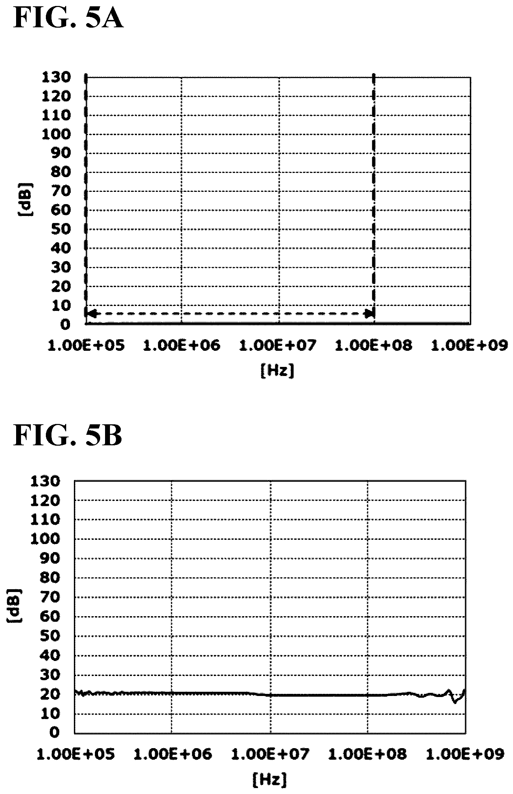

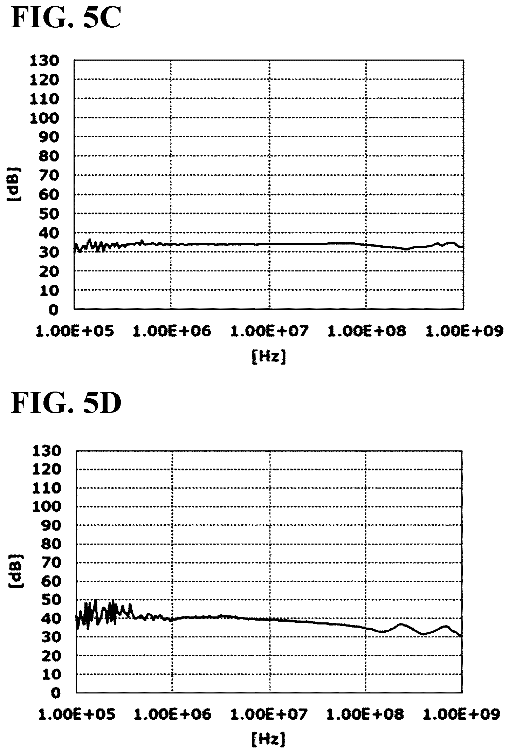

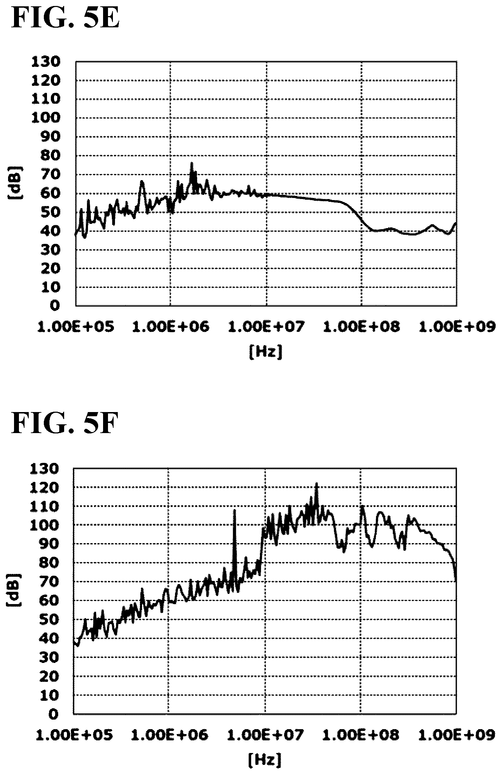

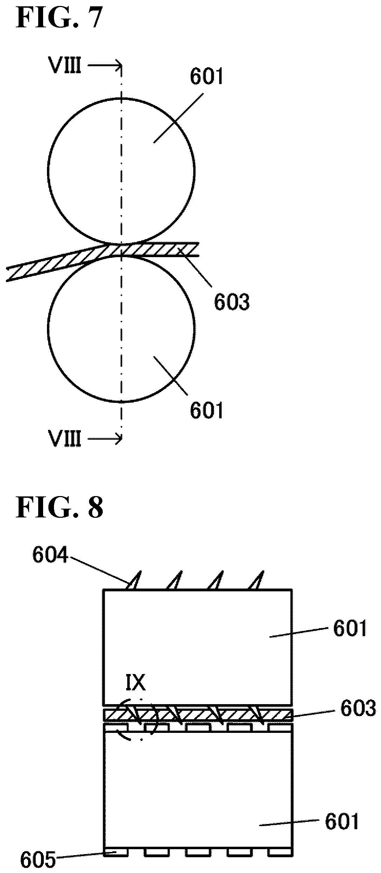

The shielding performance will be explained using the graphs drawn in FIG. 5A to FIG. 5F. FIG. 5A is a graph of the electric field-shielding performance of a polypropylene resin layer having a thickness of 150 $\mu$m. FIG. 5B is a graph of the electric field-shielding performance of a shielding layer having a thickness of 150 $\mu$m containing an aluminum thin film and a polypropylene resin in which the mass proportion W of the aluminum thin film is 25%. FIG. 5C is a graph of the electric field-shielding performance of a shielding layer having a thickness of 150 $\mu$m containing an aluminum thin film and a polypropylene resin in which the mass proportion W of the aluminum thin film is 45%. FIG. 5D is a graph of the electric field-shielding performance of a shielding layer having a thickness of 150 $\mu$m containing an aluminum thin film and a polypropylene resin in which the mass proportion W of the aluminum thin film is 65%. FIG. 5E is a graph of the electric field-shielding performance of a shielding layer having a thickness of 150 $\mu$m containing an aluminum thin film and a polypropylene resin in which the mass proportion W of the aluminum thin film is 75%. FIG. 5F is a graph of the electric field-shielding performance of an aluminum thin film having a thickness of 150 $\mu$m. In FIG. 5A to FIG. 5F, the horizontal axis represents the frequency (Hz), and the vertical axis represents the decibel (dB). For example, in the region of 0.1 MHz ($10^5$: 1.00E + 05) or more and 100 MHz ($10^8$: 1.00E + 08) or less in FIG. 5A (the region 801 indicated with the arrows in FIG. 8A), the electric field is not blocked at all. In the region of 0.1 MHz or more and 100 MHz or less in FIG. 5B, electric field-shielding performance of about 20 dB is shown. In the region of 0.1 MHz or more and 100 MHz or less in FIG. 5C, electrolytic shielding performance of about 33 dB is shown. In the region of 0.1 MHz or more and 100 MHz or less in FIG. 5D, electrolytic shielding performance of about 35 to 50 dB is shown. In the region of 0.1 MHz or more and 100 MHz or less in FIG. 5E, electrolytic shielding performance of about 35 to 76 dB is shown. In the region of 0.1 MHz or more and 100 MHz or less in FIG. 5F, electrolytic shielding performance of about 35 to 122 dB is shown.

[Thickness of Shielding Layer]

The thickness tx of the shielding layer in the invention is not limited and may be equal to or greater than the thickness ty of the metal strips. The ideal state may be a shielding layer having the same thickness tx as the thickness ty of one piece of metal strip. Even when the thickness of the shielding layer is increased, the shielding property is not greatly improved. This is because, when the thickness ty of the metal strips is 10 $\mu$m or more, the dependency on the thickness of the shielding layer is considered to be small in improving the shielding property.

However, since it is preferable to increase the density of the aggregate (increase the number of the metal strips per unit area) by reducing the thickness of the metal strips from the viewpoint of preventing gaps, it is preferable to have a portion satisfying $2 \leq tx/ty$, more preferably a portion satisfying $3 \leq tx/ty$, and still more preferably a portion satisfying $5 \leq tx/ty$, when the thickness of the shielding layer is defined as tx, and the thickness of the metal strips is defined as ty. Here, in a case in which the shielding layer is not uniform in thickness in the integrally molded article, such as a case in which the thickness of the shielding layer is different between the standing plane portion and the top surface portion, any one part is preferably in the above range.

[Shielding Layer: Reinforcing Fibers]

Reinforcing fibers may be added to the shielding layer. This is to prevent the aggregate of the metal strips from being disconnected and draping down when the shielding layer is subjected to a burning test. When reinforcing fibers are contained in the shielding layer, the ductility also improves. The reinforcing fibers mixed into the shielding layer are preferably aramid fibers, glass fibers, or carbon fibers.

[Shielding Layer: Method for Producing Shielding Layer Precursor]

The integrally molded article of the invention is preferably produced by stacking a fiber-reinforced resin containing reinforcing fibers and a first matrix resin and a shielding layer precursor and performing press-molding with an upper mold and a lower mold (sometimes together called upper and lower molds). That is, the shielding layer is obtained by molding the shielding layer precursor. The method for producing the shielding layer precursor is not limited, but the shielding layer precursor can be produced as follows.

1. Preparation of Aggregate of Metal Strips

1.1 Slitting

The aggregate of the metal strips can be produced by slitting and then cutting a metal thin film having a large width.

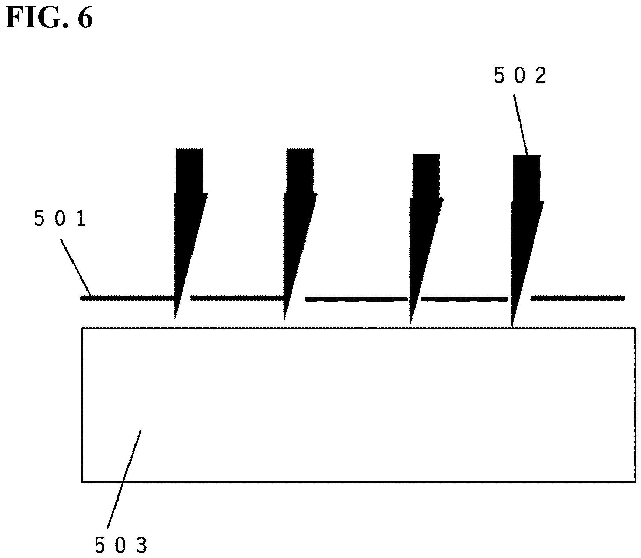

### 1.1.1 Slitting by Pressing to Roller (FIG. 6)

FIG. 6 shows a schematic view of production of narrow metal strips 501 by pressing a metal thin film against a lower support roller (a rubber roller 503) illustrated in FIG. 6 and slitting with a blade 502. As illustrated in FIG. 6, the metal thin film is slit by pressing against the rubber roller 503 having high hardness which has been subjected to heat treatment such as hardening. In this case, it is necessary to adjust so that the rubber roller 503 is not damaged and the metal thin film is not caught.

### 1.1.2 Slitting with Shear Blade (FIG. 7 to FIG. 9)

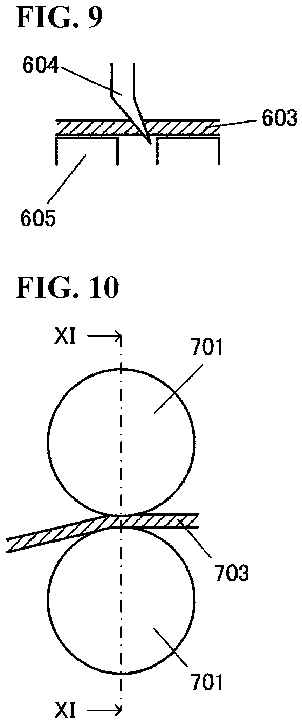

FIG. 7 to FIG. 9 show schematic views in which the metal thin film 603 is slit by the shear blade method. FIG. 7 is a side view of a state in which the metal thin film 603 passes between an upper rotary blade 601 and a lower rotary blade 602, and FIG. 8 is a cross-sectional view taken along the line VIII-VIII in FIG. 7. FIG. 9 is an enlarged view of the portion IX in FIG. 8. As illustrated in FIG. 7 to FIG. 9, an acute cutting edge 604 with a clearance angle is provided on the upper rotary blade 601 and presses the metal thin film 603 against the side surface of a tip 605 of the lower rotary blade 602 for combining the blades and cutting. In this case, highly accurate clearance management is required constantly.

### 1.1.3 Gang Method (FIG. 10 to FIG. 12)

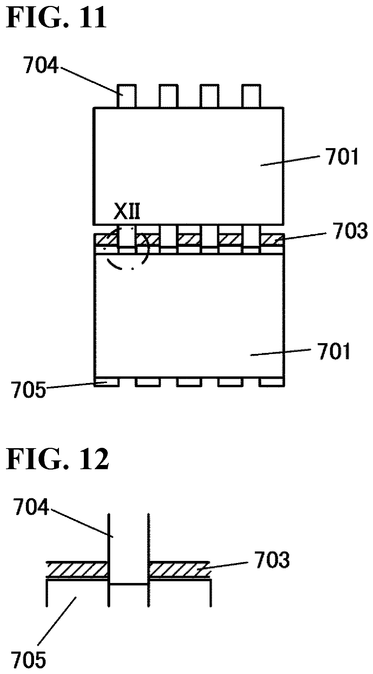

Fig. 10 to FIG. 12 show schematic views of separating reinforcing fiber bundles by the gang method. FIG. 10 is a side view of a state in which a metal thin film 673 passes between an upper rotary blade 701 and a lower rotary blade 702, and FIG. 11 is a cross-sectional view taken along the line XI-XI in FIG. 10. FIG. 12 is an enlarged view of the portion XII in FIG. 11. As illustrated in FIG. 10 to FIG. 12, an upper blade 704 provided on the upper rotary blade 701, which is a rotary round blade, and a lower blade 705 provided on the lower rotary blade are combined with each other in a configuration in which tips of the blades are overlapped with a small gap therebetween, and the reinforcing fiber bundles are sandwiched between the overlapping parts and separated with the shearing force of the overlapping parts of the upper blade and the lower blade. As with the shear blade method, highly accurate clearance management is required constantly.

### 1.2 Cutting of Slit Metal Strips

The slit metal strips are cut to a fixed length using, for example, a rotary cutter and sprayed and fixed on a resin which has been produced in advance on an air-permeable support that is provided directly below the rotary cutter, has suction mechanism at the bottom and continuously moves in one direction, and thus the aggregate of the metal strips can be obtained. The resin is preferably in a film shape or a nonwoven fabric shape.

### 2. Second Matrix Resin

The metal thin film in the shielding layer is fixed by the second matrix resin. The second matrix resin contained in the shielding layer may be thermosetting or thermoplastic. The first matrix resin and the second matrix resin are preferably the same resin. Hereinafter, the first matrix resin is also referred to as resin A, and the second matrix resin is also referred to as resin B.

### 2.1. Thermoplastic Resin

When the resin used as the first matrix resin or the second matrix resin is a thermoplastic resin, the type thereof is not limited, and a resin having a desired softening point or melting point can be appropriately selected and used. As the thermoplastic resin, a thermoplastic resin having a softening point in the range of 180°C to 350°C is generally used, but the thermoplastic resin is not limited thereto.
Examples of the thermoplastic resin include a polyolefin resin, a polystyrene resin, a polyamide resin, a polyester resin, a polyacetal resin (polyoxy methylene resin), a polycarbonate resin, a (meth)acrylic resin, a polyarylate resin, a polyphenylene ether resin, a polyimide resin, a polyether nitrile resin, a phenoxy resin, a polyphenylene sulfide resin, a polysulfone resin, a polyketone resin, a polyetherketone resin, a thermoplastic urethane resin fluorine-based resin, a thermoplastic polybenzimidazole resin, and the like.
The thermoplastic resin used in the integrally molded article of the invention may be only one type or two or more types. Examples of a mode in which two or more types of thermoplastic resins are used in combination include, but not limited to, a mode in which thermoplastic resins having different softening points or melting points are used in combination, a mode in which thermoplastic resins having different average molecular weights are used in combination, and the like.
When the thermoplastic resin is used, a polyolefin resin is more preferably used, and a polypropylene resin is further preferably used.

## 2.2. Thermosetting Resin

The first matrix resin may be a thermosetting resin. When a thermosetting resin is used, the resin is preferably an unsaturated polyester resin, a vinyl ester resin, an epoxy resin, or a phenol-based resin. As the resin, one type may be used alone, or two or more types may be used in combination.

As the fiber-reinforced resin, a sheet molding compound (sometimes referred to as SMC) containing reinforcing fibers may be used. Due to its high moldability, the sheet molding compound can be easily molded even into complex shapes. The sheet molding compound has higher fluidity and formability than continuous fibers, and ribs and bosses can be easily formed.

## 3. Adhesion of Aggregate of Metal Strips

The aggregate of the metal strips is further sandwiched with a resin from above, and a laminate having a three-layer structure of "resin/aggregate of metal strips/resin" is prepared. When the resin is a thermoplastic resin, the shielding layer precursor is completed after the resin is melted and adhered to the metal strips.

At this time, the resin may enter the aggregate of the metal strips, or may not. In order to improve the adhesion force among the metal strips, a binder may be adhered to the metal strips in advance.

In an embodiment, the aggregate of the metal strips is sandwiched and adhered using a polypropylene resin.

One sheet of the prepared shielding layer precursor 20 may be used for integral molding with the fiber-reinforced resin 10, or two or more sheets of the shielding layer precursor 20 may be used for integral molding with the fiber-reinforced resin 10 as a laminate or separately without stacking.

[Shielding Layer: Ductility]

The ductility refers to the property indicating the degree of deformation of a substance due to an external force and the capability of continuously extending without being destroyed. In general, the extensibility represents the property in which a substance is deformed due to an applied external force and stretched when the deformation continues. For example, a metal has high ductility and can be elongated when being pulled. This property is used to process a metal product or to produce a wire or the like. On the other hand, brittle materials such as glass and ceramics have low ductility and tend to be easily broken when an external force is applied. In general, the formability of a metal is inferior to that of a resin.

In the integrally molded article in the invention, the relationship between the ductility $E1$ of the fiber-reinforced resin and the ductility $E2$ of the laminate of the fiber-reinforced resin and the shielding layer precursor satisfies preferably $0.9 < E1/E2 < 50$, more preferably $1 < E1/E2 < 20$, further preferably $1 < E1/E2 < 10$, and still more preferably $1 < E1/E2 < 7$.

In the invention, it is preferable that the fiber-reinforced resin has a plate shape and that the shielding layer precursor flows and extends in the in-plane direction of the fiber-reinforced resin to produce a press molded article. In the invention, the ductility of the fiber-reinforced resin is preferably more than 1% and 300% or less, and more preferably more than 20% and 150% or less.

The ductility of the laminate of the fiber-reinforced resin and the shielding layer precursor is preferably more than 2% and 100% or less, and more preferably more than 10% and less than 80%. When the reinforcing fibers are mixed into the shielding layer precursor, the ductility improves. Further, it is preferable that $E1 > E2$. When the values of $E1$ and $E2$ are close to each other, the integrally molded article is easily molded. The method for measuring the ductility will be described later. The ductility is sometimes referred to as the extension rate and is represented by percentage.

[Shielding Layer: Comparison with Continuous Fiber Net]

As a method for causing the shielding layer to follow the fiber-reinforced resin, in an example idea, continuous metal fibers capable of shielding against an electric field or a magnetic field are used, formed in a net shape and laminated with the fiber-reinforced resin, and an integrally molded article is thus formed. By forming a net shape, the values of the ductility of the shielding layer precursor and the ductility of the fiber-reinforced resin can be made close to each other, and the moldability improves. However, when the shielding layer precursor is prepared by forming the continuous metal fibers in a net shape, the meshes (gaps) of the net are widened in the molding process (which also means that the gap is widened), and the shielding ability becomes poor. The shielding layer of the invention can reduce the influence lowering the shielding layer during molding.

[Fiber-Reinforced Resin Layer: Reinforcing Fibers]

In this specification, the reinforcing fibers are preferably at least one type selected from the group consisting of carbon fibers, aramid fibers, and glass fibers. More preferably, the reinforcing fibers are carbon fibers or glass fibers.

[Fiber-Reinforced Resin Layer: Reinforcing Fibers (Carbon Fibers)]

1. Carbon Fibers in General

When carbon fibers are used, polyacrylonitrile (PAN)-based carbon fibers, petroleum/coal pitch-based carbon fibers, rayon-based carbon fibers, cellulose-based carbon fibers, lignin-based carbon fibers, phenol-based carbon fibers, and the like are generally known, but any carbon fibers thereof can be suitably used in the invention. Of these, polyacrylonitrile (PAN)-based carbon fibers are preferably used in the invention because of their excellent tensile strength. Carbon fibers "Tenax" (registered trademark) STS40-24KS (average fiber diameter of 7 $\mu$m) manufactured by TEIJIN LIMITED can be used as the PAN-based carbon fibers, for example.

2. Sizing Agent for Carbon Fibers

The carbon fibers used in the invention may have a sizing agent attached to the surface thereof. When carbon fibers having a sizing agent attached are used, the type of the sizing agent can be appropriately selected according to the type of the carbon fibers and the type of the resin and is not limited.

[Fiber-Reinforced Resin Layer: Reinforcing Fibers (Glass Fibers)]

A case in which the reinforcing fibers used in the invention are glass fibers will be explained.

1. Glass Fibers in General

The glass fibers used in the invention may be any glass fibers generally referred to as glass fibers. The glass composition such as A glass, C glass, or E glass is not limited, and the glass fibers may sometimes contain a component such as $TiO_2$, $SO_3$, and $P_2O_5$. As the glass fibers, for example, glass fibers E-glass RS240QR-483 (count: 2400 g/1000 m) manufactured by Nitto Boseki Co., Ltd. can be used.

2. Sizing Agent for Glass Fibers

The glass fibers used in the invention may have a sizing agent attached to the surface thereof. When glass fibers having a sizing agent attached are used, the type of the sizing agent can be appropriately selected according to the type of the glass fibers and the type of the resin and is not limited. Glass fibers that are treated in advance with a conventionally known coupling agent, such as an organosilane-based compound, an organic titanium-based compound, an organoborane-based compound, and an epoxy-based compound, can be preferably used.

[Fiber-Reinforced Resin Layer: Reinforcing Fibers Dispersed in In-Plane Direction]

The reinforcing fibers of the invention are preferably discontinuous fibers and dispersed in the in-plane direction of the fiber-reinforced resin layer. Moreover, in order to disperse in the in-plane direction in the fiber-reinforced resin layer, the reinforcing fibers contained in the fiber-reinforced resin are preferably dispersed in the in-plane direction. That the reinforcing fibers are dispersed in the in-plane direction means that the reinforcing fibers are dispersed with the fiber axes of the reinforcing fibers oriented in the in-plane direction. The angles between the fiber axes of the reinforcing fibers and the in-plane direction are preferably 45° or less.

1. In-Plane Direction

The in-plane direction is an indefinite direction in parallel surfaces orthogonal to the plate thickness direction of the fiber-reinforced resin and the fiber-reinforced resin layer. The fiber-reinforced resin is preferably a plate-shaped material.

2. Random Dispersion in Two-Dimensional Direction

The reinforcing fibers are preferably randomly dispersed in the two-dimensional direction in the in-plane direction. In a region where the fiber-reinforced resin is press molded without flowing, the state of the reinforcing fibers is substantially maintained during molding. Therefore, the reinforcing fibers contained in the non-flowing region of the fiber-reinforced resin layer formed by molding the fiber-reinforced resin are also preferably dispersed two-dimensionally randomly in the in-plane direction.

Here, the phrase "two-dimensionally randomly dispersed" refers to a state in which the reinforcing fibers are not oriented in a specific direction such as one direction in the in-plane direction of the fiber-reinforced resin or the fiber-reinforced resin layer but are oriented in a disordered manner and are placed in the sheet plane without exhibiting a specific directivity as a whole. The fiber-reinforced resin or the fiber-reinforced resin layer obtained using the discontinuous fibers which are dispersed two-dimensionally randomly is substantially isotropic and has no anisotropy in the plane.

The degree of the two-dimensionally random orientation is evaluated by determining the ratio of the tensile moduli in two directions orthogonal to each other. When a ratio ($E\delta$) obtained by dividing the larger value, of measured values of tensile elastic modulus in any direction of the fiber-reinforced resin or the fiber-reinforced resin layer and in an orthogonal direction thereto, by the smaller value is 5 or less, more preferably 2 or less, and further preferably 1.5 or less, it can be evaluated that the reinforcing fibers are dispersed two-dimensionally randomly.

When the resin contained in the fiber-reinforced resin layer is a thermoplastic resin and when the fiber-reinforced resin layer is three-dimensionally shaped including a curved surface, as the method for evaluating the two-dimensionally random dispersion in the in-plane direction, the fiber-reinforced resin layer may be heated to the softening temperature or higher, returned to a flat plate shape and then solidified. After that, a test piece is cut out, the tensile moduli are obtained, and then the random dispersion state in the two-dimensional direction can be examined.

[Fiber-Reinforced Resin Layer: Fiber Length of Reinforcing Fibers]

The reinforcing fibers are preferably discontinuous fibers. When discontinuous fibers are used, the formability improves compared to that of fiber-reinforced plastics using only continuous fibers, and it becomes easy to produce a complicated fiber-reinforced resin layer. Since the weight average fiber length of the reinforcing fibers does not change during molding, by examining the weight average fiber length of the reinforcing fibers of the fiber-reinforced resin layer, the weight average fiber length Lw of the reinforcing fibers contained in the fiber-reinforced resin can be determined.

The weight average fiber length Lw of the reinforcing fibers is preferably 1 mm or more, and more preferably 3 mm or more. The weight average fiber length Lw of the reinforcing fibers is more preferably 3 mm or more and 100 mm or less, more preferably 3 mm or more and 80 mm or less, and further preferably 5 mm or more and 60 mm or less. When the weight average fiber length Lw of the reinforcing fibers is 100 mm or less, the fluidity of the fiber-reinforced resin is less likely to decrease in producing the fiber-reinforced resin by press molding, and a desired shape is easily formed. Moreover, when the weight average fiber length Lw is 1 mm or more, the mechanical strength of the obtained fiber-reinforced resin member is less likely to decrease, which is preferable.

The weight average fiber length Lw and the number average fiber length Ln of the reinforcing fibers are determined by the following equations (1) and (2).

In the fiber-reinforced resin layer formed by injection molding, the weight average fiber length of the reinforcing fibers is about 0.1 to 0.3 mm. Therefore, when the weight average fiber length of the reinforcing fibers is adjusted to 1 mm or more and 100 mm or less, the fiber-reinforced resin layer is preferably formed by press molding.

In the invention, discontinuous reinforcing fibers having different fiber lengths may be used in combination. In other words, the discontinuous reinforcing fibers used in the invention may have a single peak or a plurality of peaks in the distribution of the weight average fiber length.

[Fiber-Reinforced Resin Layer: Number Average Fiber Length Ln and Weight Average Fiber Length Lw of Reinforcing Fibers]

In general, the number average fiber length Ln and the weight average fiber length Lw are determined by the following equations (1) and (2), where the fiber length of each reinforcing fiber is represented by Li. Here, the unit of the number average fiber length Ln and the weight average fiber length Lw is mm.

[Math. 1]

$$Ln = \sum_{i=1}^{I} \frac{Li}{I} \quad \cdots (1)$$

$$Lw = (\sum_{i=1}^{I} Li^2)/(\sum_{i=1}^{I} Li) \quad \cdots (2)$$

Here, "I" represents the number of measured reinforcing fibers.

When the fiber length is a constant length, the number average fiber length and the weight average fiber length are the same values. The reinforcing fibers can be extracted from the fiber-reinforced resin layer, for example, by heat-treating the fiber-reinforced resin layer at 500°C for about one hour and removing the resin in a furnace.

The average fiber length can be determined, for example, by measuring the fiber lengths of 100 fibers randomly extracted from the fiber-reinforced resin layer in 1 mm increment using a caliper or the like and determining based on the equation (1) or the equation (2).

When short fibers that could not be measured with a caliper were contained, the resin was removed, and then the obtained reinforcing fibers were put into water containing a surfactant and sufficiently stirred by ultrasonic vibration. The stirred dispersion is randomly taken with a measuring spoon to obtain a sample for evaluation, and the lengths of 3000 fibers are preferably measured by an image analyzer Luzex AP manufactured by Nireco Corporation. Using the measured values of the fiber lengths, the number average fiber length Ln and the weight average fiber length Lw can be determined similarly as in the above equations (1) and (2).

[Fiber-Reinforced Resin Layer: Fiber Volume Fraction of Reinforcing Fibers]

The fiber volume fraction Vf of the reinforcing fibers is not limited but is preferably 20 to 70%, more preferably 25 to 60%, and further preferably 30 to 55%. Here, the fiber volume fraction (Vf, unit: volume%) is the proportion of the volume of the reinforcing fibers in the total volume including not only the reinforcing fibers and the resin but also other additives and the like.

The analysis of the volume fraction of the reinforcing fibers is not limited, but the volume fraction is preferably measured as follows.

A sample is cut out from the fiber-reinforced resin layer, and the resin is burned and removed in a furnace at 500°C for one hour. The mass of the sample is measured before and after the treatment to calculate the mass of the reinforcing fibers, the resin, and the other additives. Next, the volume fractions of the reinforcing fibers and the resin are calculated using the specific gravities of the components.

$$Vf = 100 \times \text{reinforcing fiber volume}/(\text{reinforcing fiber volume} + \text{resin volume} + \text{other additives})$$

[Fiber-Reinforced Resin Layer: First Matrix Resin]

The first matrix resin contained in the fiber-reinforced resin layer may be thermosetting or thermoplastic.

1. Thermoplastic Resin

When the used resin is a thermoplastic resin, the type thereof is not limited, and one having a desired softening point or melting point can be appropriately selected and used. As the thermoplastic resin, a thermoplastic resin having a softening point in the range of 180°C to 350°C is generally used, but the thermoplastic resin is not limited thereto.

Examples of the thermoplastic resin include a polyolefin resin, a polystyrene resin, a polyamide resin, a polyester resin, a polyacetal resin (polyoxy methylene resin), a polycarbonate resin, a (meth)acrylic resin, a polyarylate resin, a polyphenylene ether resin, a polyimide resin, a polyether nitrile resin, a phenoxy resin, a polyphenylene sulfide resin, a polysulfone resin, a polyketone resin, a polyetherketone resin, a thermoplastic urethane resin fluorine-based resin, a thermoplastic polybenzimidazole resin, and the like.

The thermoplastic resin used in the fiber-reinforced resin layer of the invention may be only one type or two or more types. Examples of a mode in which two or more types of thermoplastic resins are used in combination include, but not limited to, a mode in which thermoplastic resins having different softening points or melting points are used in combination, a mode in which thermoplastic resins having different average molecular weights are used in combination, and the like. When the thermoplastic resin is used, a polyolefin resin is more preferably used, and a polypropylene resin is further preferably used.

2. Thermosetting Resin

The first matrix resin may be a thermosetting resin. When a thermosetting resin is used, the resin is preferably an unsaturated polyester resin, a vinyl ester resin, an epoxy resin, or a phenol-based resin. As the resin, one type may be used alone, or two or more types may be used in combination.

As the fiber-reinforced resin, a sheet molding compound (sometimes referred to as SMC) containing reinforcing fibers may be used. Due to its high moldability, the sheet molding compound can be easily molded even into complex shapes. The sheet molding compound has higher fluidity and formability than continuous fibers, and ribs and bosses can be easily formed.

[Fiber-Reinforced Resin Layer: Other Agents]

The first matrix resin used for the fiber-reinforced resin may contain an additive such as various fibrous fillers such as organic fibers or inorganic fibers, non-fibrous fillers, flame retardants, UV resistant agents, stabilizers, mold release agents, pigments, softeners, plasticizers, and surfactants, within a range not impairing the object of the invention. When the thermosetting resin is used, a thickener, a curing agent, a polymerization initiator, a polymerization inhibitor, or the like may be contained. As the additive, one type may be used alone, or two or more types may be used in combination.

[Thermoplastic Resin and Non-Flow Molding]

The first matrix resin and the second matrix resin of the invention are preferably the same type of thermoplastic resin. Moreover, since it is necessary that the shielding layer precursor is molded following the fiber-reinforced resin, the fiber-reinforced resin is preferably not flow molded during molding. More preferably, the first matrix resin and the second matrix resin are the same type of thermoplastic resin, and the area charge rate of the fiber-reinforced resin to the total area of the mold cavity is 80% or more. Further preferably, the area charge rate of the shielding layer precursor to the total area of the mold cavity is 80% or more.

[Production Method: Integral Molding]

The integrally molded article of the invention is an integrally molded article of the fiber-reinforced resin layer containing the reinforcing fibers and the first matrix resin and the shielding layer. The integrally molded article is obtained by integrally molding the fiber-reinforced resin layer containing the reinforcing fibers and the first matrix resin and the shielding layer. Here, integral molding means that the members are continuously molded without a seam and are not molded by joining separate members. In such integral molding, a molded article is formed by one molding, which can be preferably conducted by press molding. By being formed by integral molding, separate parts can be processed as one component, and the unit price of the component can be reduced. Further, the number of assembling steps is reduced, and the cost of inventory can be reduced by reducing the number of components.

[Production Method: Press Molding]

The integrally molded article of the invention may be produced by stacking the fiber-reinforced resin containing the reinforcing fibers and the first matrix resin and the shielding layer precursor and press molding the laminate using upper and lower molds.

More specifically, when the first matrix resin and the second matrix resin are thermoplastic resins, the fiber-reinforced resin and the shielding layer precursor are heated, and the heated fiber-reinforced resin and the shielding layer precursor are laminated and simultaneously pressed in the mold to produce an integrally molded article.

1. Fiber-Reinforced Resin and Shielding Layer Precursor

The method for stacking the fiber-reinforced resin and the shielding layer precursor is not limited, but since the shielding layer precursor has high followability to the fiber-reinforced resin, the two in the same size may be laminated.

The volume fractions of the fiber-reinforced resin $V_x$ and the shielding layer precursor $V_y$ are not limited, but $V_x:V_y$ is preferably 99:1 to 60:40, and more preferably 98:2 to 66:34. Within this range, the shielding layer does not become too thick, and the moldability is excellent.

2. Hot Press Molding and Cold Press Molding

As the molding method in the invention, press molding (also referred to as compression molding) is used, and a molding method such as hot press molding and cold press molding can be used.

2.1 Cold Press Molding

When a thermoplastic resin is used as the resin, press molding using cold pressing is preferable. In the cold press molding method, for example, the fiber-reinforced resin and the shielding layer precursor which are heated to a first predetermined temperature are charged into a mold set to a second predetermined temperature and then pressurized and cooled.

Specifically, when the thermoplastic resin constituting the fiber-reinforced resin and the shielding layer precursor is crystalline, the first predetermined temperature is equal to or higher than the melting point, and the second predetermined temperature is lower than the melting point. When the thermoplastic resin is amorphous, the first predetermined temperature is equal to or higher than the glass transition temperature, and the second predetermined temperature is lower than the glass transition temperature. That is, the cold pressing method includes at least the following steps A-1) and A-2).

Step A-1) A step of heating to a temperature equal to or higher than the melting point but equal to or lower than the decomposition temperature when the thermoplastic resin is crystalline or to a temperature equal to or higher than the glass transition temperature but equal to or lower than the decomposition temperature when the thermoplastic resin is amorphous.

Step A-2) A step of placing the fiber-reinforced resin and the shielding layer precursor heated in step A-1) in a mold whose temperature is adjusted to be lower than the melting point when the thermoplastic resin is crystalline or to be lower than the glass transition temperature when the thermoplastic resin is amorphous and pressurizing. By performing these steps, molding of the fiber-reinforced resin and the shielding layer precursor can be completed (a press molded article can be produced).

It is required to perform the above steps in the above order, but another step may be included between the steps. The other step may be, for example, a shaping step of pre-shaping into the shape of the cavity of the mold using a shaping mold different from the mold used in step A-2) prior to step A-2) or the like.

The shape of at least one of the fiber-reinforced resin and the shielding layer precursor may be a shape developed by a computer through reverse molding analysis from the three-dimensional shape of the press molded article to be produced.

2.2 Hot Press Molding

In the hot press molding method, for example, the fiber-reinforced resin is charged into a mold and pressurized while the temperature of the mold is increased to a first predetermined temperature, and the mold is cooled to a second predetermined temperature. Specifically, when the thermoplastic resin constituting the fiber-reinforced resin and the shielding layer precursor is crystalline, the first predetermined temperature is equal to or higher than the melting point, and the second predetermined temperature is lower than the melting point. When the thermoplastic resin constituting the fiber-reinforced resin and the shielding layer precursor is amorphous, the first predetermined temperature is equal to or higher than the glass transition temperature, and the second predetermined temperature is lower than the glass transition temperature.

The hot press molding preferably includes at least the following steps B-1) to B-4).

B-1) A step of placing the fiber-reinforced resin and the shielding layer precursor in a mold (lower mold).

B-2) A step of pressurizing while heating the mold to a temperature equal to or higher than the melting point of the thermoplastic resin but equal to or lower than the thermal decomposition temperature when the thermoplastic resin is crystalline or to a temperature equal to or higher than the glass transition temperature of the thermoplastic resin and equal to or lower than the thermal decomposition temperature when the thermoplastic resin is amorphous (first pressing step).

B-3) One or more pressurizing steps in which the pressure in the final step is 1.2 times the pressure in the first pressing step or more and 100 times or less (second pressing step).

B-4) A step of adjusting the mold temperature to a temperature lower than the melting point when the thermoplastic resin is crystalline or to a temperature lower than the glass transition temperature when the thermoplastic resin is amorphous.

By performing these steps, an integrally molded article can be formed.

3. Common Matters of Cold Press Molding Method and Hot Press Molding Method

Steps A-2) and B-3) are steps of applying pressure to the fiber-reinforced resin and the shielding layer precursor to obtain a molded article having a desired shape, but the molding pressure at this time is not limited but is preferably as low as possible within a range in which a desired structural body shape can be obtained. Specifically, the molding pressure is preferably less than 30 MPa, more preferably 20 MPa or less, and further preferably 10 MPa or less, with respect to the projected area of the mold cavity. A molding pressure of less than 30 MPa is preferable because capital investment or maintenance cost of the press machine is not required. As a matter of course, various steps may be inserted in the above steps during compression molding, and, for example, vacuum compression molding, in which compression molding is performed under vacuum, may be used.

4. Arrangement of Fiber-Reinforced Resin and Shielding Layer Precursor (Stacking Order)

The order in which the fiber-reinforced resin and the shielding layer precursor are laminated is not limited, but when cold press molding is performed, the fiber-reinforced resin and the shielding layer precursor are preferably placed in the mold in such a manner that the design surface comes into contact with the upper mold and press molded. For example, in a case in which the shielding layer is the design surface, the fiber-reinforced resin and the shielding layer precursor are preferably laminated and placed in this order in the mold in such a manner that the fiber-reinforced resin is in contact with the lower mold and cold press molded. In the case of cold press molding, unless the material forming the design surface (for example, the shielding layer precursor) is brought into contact with the lower mold, the thermoplastic resin of the material forming the design surface is not cooled until immediately before pressing (until the material forming the design surface comes into contact with the upper mold), and thus the mirror surface of the mold is easily transferred.

[Production Method: RTM Molding]

The integrally molded article of the invention can also be produced using RTM molding (Resin Transfer Molding). For example, a fabric base material using reinforcing fibers such as glass fibers and carbon fibers is placed in advance in the mold in a dry fabric state without the first matrix resin. At this time, the shielding layer precursor is placed on the fabric base material in the dry fabric state, and the mold is closed. Thereafter, the mold is filled with a thermosetting second matrix resin such as an epoxy resin having excellent fluidity (easily bleeding into fibers). When the resin spreads, the mold may be heated to promote curing of the epoxy resin. Also by this method, the integrally molded article of the invention, in which the fiber-reinforced resin layer containing the reinforcing fibers and the first matrix resin and the shielding layer are integrally molded, can be formed.

Moreover, a first matrix resin that cures at a temperature lower than the softening temperature of the second matrix resin is preferably used. This is because, by setting the mold temperature of the mold for RTM molding to be lower than the softening temperature of the second matrix resin, the shielding layer is also solidified when the molding of the fiber-reinforced resin layer is completed.

If a first matrix resin that cures at a temperature higher than the softening temperature of the second matrix resin is used, by providing a step of lowering the mold temperature to the softening temperature of the second matrix resin or lower after the mold temperature of the mold for RTM molding is set to be higher than the softening temperature of the second matrix resin to cure the first matrix resin, the fiber-reinforced resin layer and the shielding layer can be released from the mold in a solidified state.

In recent years, development of a resin having a high curing rate has progressed, and RTM molding contributes to mass production of large composite products.

[Shape of Integrally Molded Article]

The integrally molded article 1A has a flat plane portion and a standing plane portion. Specifically, the integrally molded article preferably has at least one flat plane portion having at least one thickness (plate thickness). The integrally molded article may have a three-dimensional shape including a T-shaped, L-shaped, U-shaped, or hat-shaped (hat shape) cross-sectional shape and may further have an uneven shape (for example, a rib, a boss, or the like).

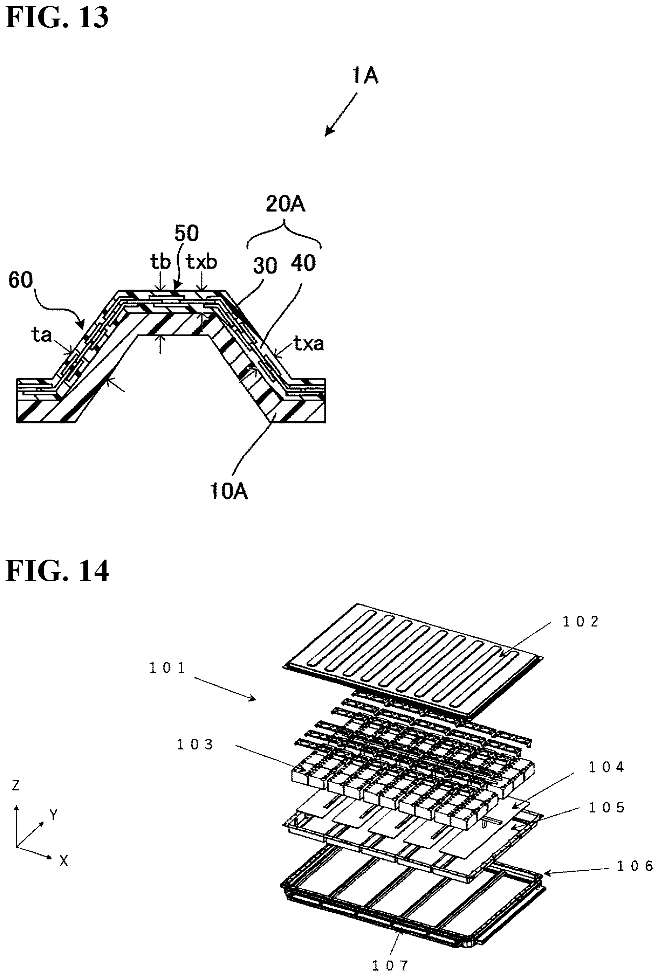

FIG. 13 is a cross-sectional view of an example of the integrally molded article 1A of an embodiment of the invention. The integrally molded article 1A is obtained by molding the laminate 1 illustrated in FIG. 1. As illustrated in FIG. 13, the integrally molded article 1A produced by the invention preferably has a cross-sectional shape having a shape including a hat-shaped portion having a top surface portion 50 and a standing plane portion 60. The top surface portion 50 is an example of the flat plane portion. For example, a side door, a rear door, or a roof for an automobile may include the standing plane portion and the top surface portion of the invention.

The thickness ta of the standing plane portion of the integrally molded article 1A and the thickness tb of the top surface portion preferably satisfy ta ≤ tb. It is more preferable to satisfy ta × 0.8 < tb and further preferable to satisfy ta × 0.6 < tb. For example, when a shielding layer precursor 20 and a fiber-reinforced resin 10 in a plate shape are used, the thickness of the laminate 1 of the shielding layer precursor 20 and the fiber-reinforced resin 10 is a uniform thickness. When a hat-shaped integrally molded article is formed using this, the standing plane portion tends to be stretched by the mold and become thinner than the top surface portion.

On the other hand, in the integrally molded article 1A of the invention, when the thickness ta of the standing plane portion 60 and the thickness tb of the top surface portion 50 are adjusted to the same thickness, it is preferable to satisfy txa ≤ txb and ta - txa ≥ tb - txb, when the thickness of the shielding layer 20A in the standing plane portion 60 is defined as txa, the thickness of the fiber-reinforced resin layer 10A is defined as ta - txa, the thickness of the shielding layer 20A in the top surface portion 50 is defined as txb, and the thickness of the fiber-reinforced resin layer 10A is defined as tb - txb.

That is, since the fiber-reinforced resin 10 has larger ductility than the shielding layer precursor 20, the thickness of the standing plane portion 60 can be easily increased during molding.

[Integrally Molded Article: Battery Tray and Battery Cover]

The integrally molded article is preferably a vehicle structure. The vehicle structure is preferably a component of a battery box, and the component of the battery box is preferably placed at the lower portion of the vehicle body.

FIG. 14 is an exploded perspective view of a battery box 101 using the integrally molded article of the embodiment. The battery box 101 has a battery cover 102, a battery 103, a temperature control system (cooling mechanism) 104, a battery tray 105, a reinforcing frame 106, and an energy absorbing member 107. The integrally molded article of the embodiment can be used for the battery cover 102 and the battery tray 105. The battery 103 is stored in the battery box 101 having the battery tray 105 and the battery cover 102.

[Battery Tray: In General]

Hereinafter, a case in which a battery tray is used as the vehicle structure will be described. The battery tray 105 is for driving an automobile for mounting the battery 103 for driving a vehicle.

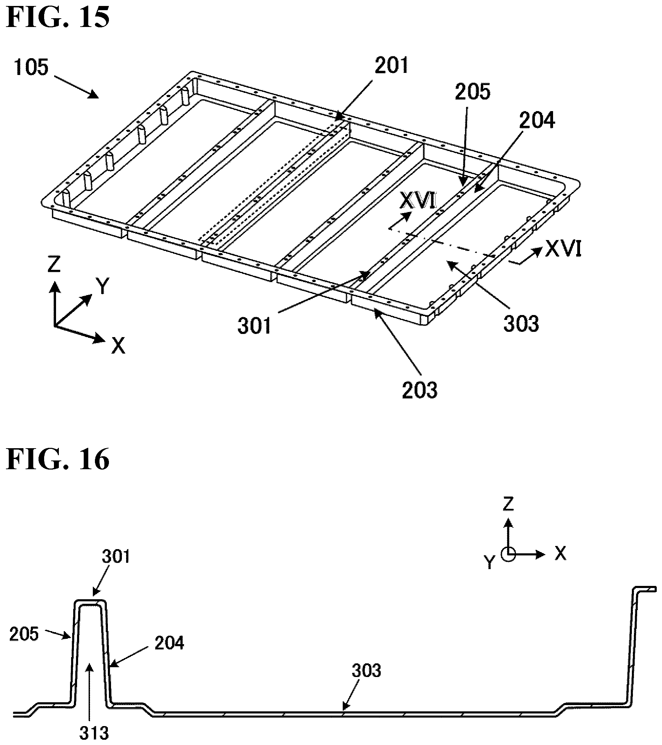

FIG. 15 is a perspective view of the battery tray 105, and FIG. 16 is a cross-sectional view taken along XVI-XVI in FIG. 15. As illustrated in FIG. 15 and FIG. 16, the battery tray 105 has a first bottom surface portion 303 and a peripheral wall 203 standing on the outer periphery of the first bottom surface portion 303. In addition, a first inner wall 204 connected to the first bottom surface portion 303, a second inner wall 205 connected to the first bottom surface portion 303, and a second bottom surface portion 301 connected to both the first inner wall 204 and the second inner wall 205 and raised from the first bottom surface portion are provided.

The first bottom surface portion 303, the peripheral wall 203, the first inner wall 204, the second inner wall 205, and the second bottom surface portion 301 are configured as a part of the vehicle structure.

[Battery Tray and Shielding Layer]

When the vehicle structure is the battery box 101, the battery box 101 has a shielding layer that shields against an electric field or a magnetic field in order to shield against electromagnetic waves generated from the battery 103. The shielding layer can shield against electromagnetic waves radiated from the battery 103 to prevent radiation and leakage to the outside, ensure sufficient electromagnetic wave-shielding property in the battery box and suppress, for example, adverse effects of electromagnetic waves on the control system of the vehicle and the human body.

[Shielding Layer: Following Recess]

The shape of the battery box illustrated in FIG. 15 and FIG. 16, for example, is complicated, and a large recess is present as indicated by 313 in FIG. 15. While how to cover such a recess with the shielding layer is a problem, when the shielding layer precursor of the invention is used, it is easy to cause the shielding layer to follow such a recess shape.

EXAMPLES

2. Evaluation

2.1 Shielding Property

A test piece (flat plate shape) of 150 mm × 150 mm was sampled from the integrally molded article, and the radio wave-shielding property was measured for an electric field wave (frequency of more than 0 MHz and 100 MHz) by a network analyzer (manufactured by Keysight Technologies) and a KEC method measurement apparatus (manufactured by JSE). A larger numerical value means that the radio wave-shielding property is more excellent.

Good: In the entire region of more than 0 MHz and 100 MHz or less, the electrolytic shielding property is 40 decibels or more.

Bad: In the entire region of more than 0 MHz and 100 MHz or less, the electrolytic shielding property is 5 decibels or less.

2.2 Measurement of Ductility of Laminate of Shielding Layer Precursor and Fiber-Reinforced Resin

2.2.1 Measurement of Molding Heating Temperature

(1) A fiber-reinforced resin (or a laminate of a shielding layer precursor and a fiber-reinforced resin) cut into 200 mm $\times$ 200 mm is prepared.

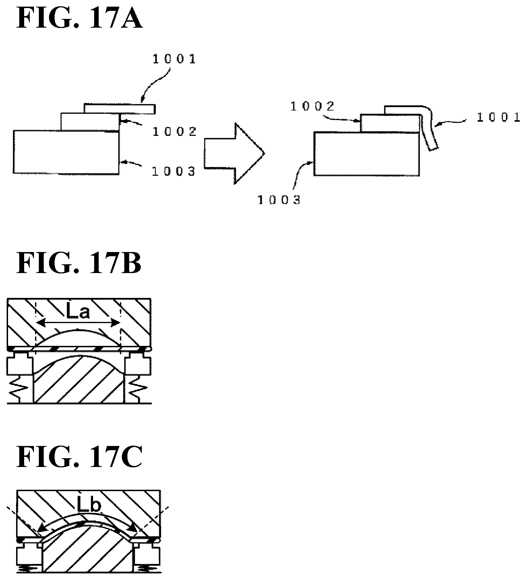

(2) As in FIG. 17A, an area of 100 mm $\times$ 200 mm, which is a half of the region, of the fiber-reinforced resin 1001 (or the laminate of the shielding layer precursor and the fiber-reinforced resin) is placed on a wire mesh 1002, and the wire mesh 1002 is placed on a stage 1003 made of a metal block and heated by an IR oven (infrared heater). The temperature is measured when the elastic modulus of the fiber-reinforced resin (or the laminate of the shielding layer precursor and the fiber-reinforced resin) decreases and the fiber-reinforced resin (or the laminate of the shielding layer precursor and the fiber-reinforced resin) sags by 10 mm from the original height under its own weight, and the temperature at this time is defined as the softening temperature. The temperature which is +50°C from the temperature is set as the molding heating temperature below.

2.2.2 Press Molding

(1) A fiber-reinforced resin (or a laminate of a shielding layer precursor and a fiber-reinforced resin) heated to the softening temperature +50°C, which is the molding heating temperature, is placed in a mold having a spherical surface of $\varphi$ 150 mm in a plan view (FIG. 17B).

At this time, the diameter ($\varphi$ 150 mm) of the spherical surface in a plan view before the start of the press molding is defined as the route length La before molding. This is press molded under the following conditions.

Press descending speed: 100 mm/sec
Clamping speed: 10 mm/sec
Molding load: 80 ton
Mold: open cavity
Mold temperature: 60°C

(2) Next, samples having different route lengths Lb after molding (for example, the arc length Lb in FIG. 17C) are created by changing the descent height of the upper mold. The obtained samples are visually observed by looking through the samples, and the maximum route length Lb of the samples in which no light leakage is observed is defined as the maximum extension length.

(3) The ductility (%) is measured by the following equation.

$$\text{Ductility (\%)} = (Lb - La)/La \times 100$$

(4) Ductility of Fiber-Reinforced Resin and Laminate of Shielding Layer Precursor and Fiber-Reinforced Resin

The ductility E1 of the fiber-reinforced resin and the ductility E2 of the laminate of the fiber-reinforced resin and the shielding layer precursor are calculated, and the value of E1/E2 is calculated.

The thickness of the shielding layer precursor was regarded as the thickness tx of the shielding layer of the top surface portion after molding, and tx/ty was calculated.

[Example 1]

1. Shielding Layer Precursor

As a thermoplastic resin of a first layer, a non-woven fabric of a polypropylene resin (NOVATEC (registered trademark) PPBC03C manufactured by Japan Polypropylene Corporation) was prepared.

Next, an aluminum foil (manufactured by UACJ foil) having a width of 20 cm and a thickness of 0.012 mm as a metal thin film was slit using a rotary slit having a pitch of 3 mm and further cut to a fixed length using a rotary cutter to obtain metal strips having a length of 10 mm, a width of 3 mm, and a thickness of 0.012 mm, and the metal strips were sprayed and fixed on the thermoplastic resin nonwoven fabric (the thermoplastic resin of the first layer) which was produced in advance on an air-permeable support that was provided directly below the rotary cutter and was continuously moving in one direction. Thus, an aggregate of the metal strips was obtained.

Further, a polypropylene resin (NOVATEC PBC03C manufactured by Japan Polypropylene Corporation) was laid on the produced aggregate of the metal strips from above using a feeder to provide a thermoplastic resin of a second layer, and a composite composition in which the thermoplastic resin of the first layer/the aggregate of the metal strips/the thermoplastic resin of the second layer were laminated in this order was obtained. The prepared composite composition was heated at 2.0 MPa for five minutes with a press heated to 250°C and cooled to obtain a shielding layer precursor having a thickness of 0.15 mm and a size of 600 mm × 1000 mm.

2. Fiber-Reinforced Resin

As glass fibers, glass fibers E-glass RS240QR-483 manufactured by NITTO BOSEKI CO., LTD. having a sizing agent attached thereto which were cut to a fiber length of 20 mm were used, and a particulate polypropylene resin (NOVATEC PP BC03C manufactured by Japan Polypropylene Corporation) having an average particle diameter of about 710 $\mu$m was used as a thermoplastic resin.

A composite composition of the glass fibers and the polypropylene resin in which the glass fibers were two-dimensionally randomly oriented was prepared based on the method described in U.S. patent No. 8946342.

Specifically, an air-permeable support that had suction mechanism at the bottom and that was continuously moving in one direction was installed, and while suctioning by the suction mechanism, the glass fibers and the polypropylene resin were blown onto the upper portion of the air-permeable support by compressed air from a tapered tube placed above the air-permeable support. Thus, a composite product in which the glass fibers and the polypropylene resin were mixed was produced.

The obtained composite composition was heated at 2.0 MPa for five minutes with a press heated to 250°C to prepare a fiber-reinforced resin having an average thickness of 3 mm and a size of 600 mm × 1000 mm. The properties of the shielding layer precursor and the fiber-reinforced resin are summarized in Table 1.

3. Cold Pressing

The fiber-reinforced resin and the shielding layer precursor were heated to 220°C by an infrared heater. Thereafter, the fiber-reinforced resin (one sheet) and the shielding layer precursor (one sheet) were laminated, in such a manner that the fiber-reinforced resin would come into contact with the lower mold and that the shielding layer precursor would come into contact with the upper mold, and placed in the mold. The upper mold was lowered to pressurize for one minute at a press pressure of 20 MPa (the time required until reaching 20 MPa from the start of pressurization was one second), and the fiber-reinforced resin and the shielding layer precursor were simultaneously pressed to produce an integrally molded article having a top surface portion, a standing plane portion, and a corner formed by the top surface portion and the standing plane portion connected to each other. The results are shown in Table 1.

[Example 2]

An integrally molded article was produced in the same manner as in Example 1 except that three sheets of the prepared shielding layer precursor were used. The results are shown in Table 1.

[Example 3]

An integrally molded article was produced in the same manner as in Example 1 except that the glass fibers were mixed into the polypropylene resin of the shielding layer precursor at a mass proportion of 10%. The results are shown in Table 1.

[Example 4]

An integrally molded article was produced in the same manner as in Example 1 except that the thermoplastic resin used in the fiber-reinforced resin was changed to polyamide 6 resin (A1030 manufactured by UNITIKA LTD.). The results are shown in Table 1.

[Comparative Example 1]

A metal thin film (an aluminum foil (manufactured by UACJ foil) having a width of 20 cm and a thickness of 0.050 mm) was cut to 1000 mm without slitting and was sandwiched between nonwoven fabrics of a polypropylene resin as it was to prepare a shielding layer precursor. Although an attempt was made to form an integrally molded article by cold pressing using the shielding layer precursor and the same fiber-reinforced resin as that in Example 1, the aluminum foil was broken during molding, and a shielding layer could not be formed.

[Table 1]

|  | Example 1 | Example 2 | Example 3 | Example 4 | Comparative Example 1 |
|---|---|---|---|---|---|
| Shielding layer precursor |  |  |  |  |  |
| Width (mm) of metal strips | 3 | 3 | 3 | 3 | 200 |
| Length (mm) of metal strips | 10 | 10 | 10 | 10 | - |
| Thickness ty (mm) of metal strips | 0.012 | 0.012 | 0.012 | 0.012 | 0.050 |
| Type of resin B | PP | PP | PP | PP | PP |
| Mass proportion (wt%) of resin B | 50 | 50 | 50 | 50 | 50 |
| Thickness tx (mm) of shielding layer precursor | 0.15 | 0.15 | 0.15 | 0.15 | 0.5 |
| tx/ty | 12.5 | 12.5 | 12.5 | 12.5 | - |
| GF (wt%) | 0 | 0 | 10 | 0 | 0 |
| Fiber-reinforced resin |  |  |  |  |  |
| Type of reinforcing fibers | GF | GF | GF | GF | GF |
| Fiber length (mm) | 20 | 20 | 20 | 20 | 20 |
| Type of resin A | PP | PP | PP | PA6 | PP |
| Thickness (mm) | 3 | 3 | 3 | 3 | 3 |
| Number of stacked sheets |  |  |  |  |  |
| Shielding layer precursor (sheet) | 1 | 3 | 1 | 1 | - |
| Fiber-reinforced resin (sheet) | 1 | 1 | 1 | 1 | 1 |
| Press molding | Placing molding materials in lower mold | Placing molding materials in lower mold | Placing molding materials in lower mold | Placing molding materials in lower mold | Placing molding materials in lower mold |
| Integrally molded article |  |  |  |  |  |
| Standing plane portion |  |  |  |  |  |
| Thickness txa (mm) of shielding layer | 0.14 | 0.44 | 0.14 | 0.14 | Unmoldable |
| Thickness ta - txa (mm) of molded article | 2.51 | 2.51 | 2.51 | 2.51 | Unmoldable |

(continued)

| Integrally molded article | | | | | |
|---|---|---|---|---|---|
| Standing plane portion | | | | | |
| Thickness ta (mm) of integrally molded article | 2.65 | 2.95 | 2.65 | 2.65 | Unmoldable |
| Top surface portion | | | | | |
| Thickness txb (mm) of shielding layer | 0.15 | 0.45 | 0.15 | 0.15 | Unmoldable |
| Thickness tb - txb (mm) of molded article | 2.5 | 2.5 | 2.5 | 2.5 | Unmoldable |
| Thickness tb (mm) of integrally molded article | 2.65 | 2.95 | 2.65 | 2.65 | Unmoldable |
| Ductility | | | | | |
| Ductility E1 (%) of fiber-reinforced resin | 100 | 100 | 100 | 86.7 | - |
| Ductility E2 (%) of laminate of fiber-reinforced resin and shielding layer precursor | 20 | 47 | 67 | 20 | - |
| E1/E2 | 5 | 2.1 | 1.5 | 4.3 | - |
| Shielding property | Good | Good | Good | Good | - |

## Claims

1. An integrally molded article comprising:

   a fiber-reinforced resin layer containing reinforcing fibers and a first matrix resin; and
   a shielding layer,
   wherein the shielding layer is a layer including an aggregate of metal strips and a second matrix resin and shields against at least one of an electric field and a magnetic field, and
   the aggregate of the metal strips is formed of metal strips dispersed in the plane of the shielding layer.

2. The integrally molded article according to claim 1,
   wherein the integrally molded article comprises a top surface portion and a standing plane portion.

3. The integrally molded article according to any one of claims 1 and 2, comprising a portion satisfying $2 \leq tx/ty$, when the thickness of the shielding layer is defined as tx, and the thickness of the metal strips is defined as ty.

4. The integrally molded article according to any one of claims 1 to 3,
   wherein the mass proportion W (metal) of the aggregate of the metal strips in the shielding layer is 30% or more.

5. The integrally molded article according to any one of claims 1 to 4,
   wherein the metal strips have a width of 1 mm or more and 40 mm or less, a length of 1 mm or more and 100 mm or less, and a thickness of 100 $\mu$m or less.

6. The integrally molded article according to any one of claims 1 to 5,
   wherein the reinforcing fibers are discontinuous fibers and are dispersed in the in-plane direction of the fiber-reinforced resin layer.

7. The integrally molded article according to any one of claims 1 to 6,
   wherein the shielding layer has a property of shielding against an electric field or a magnetic field of 10 decibels or more in at least a part of a region of more than 0 MHz and 3000 MHz or less.

8. The integrally molded article according to any one of claims 1 to 6,
wherein the shielding layer has a property of shielding against an electric field or a magnetic field of 10 decibels or more in at least a part of a region of more than 0 MHz and 100 MHz or less.

9. The integrally molded article according to claim 2,
wherein the thickness ta of the standing plane portion and the thickness tb of the top surface portion satisfy $ta \leq tb$.

10. The integrally molded article according to claim 9,
wherein the integrally molded article satisfies $txa \leq txb$ and $ta - txa \geq tb - txb$, when the thickness of the shielding layer in the standing plane portion is defined as txa, and the thickness of the fiber-reinforced resin layer is defined as ta - txa, the thickness of the shielding layer in the top surface portion is defined as txb, and the thickness of the fiber-reinforced resin layer is defined as tb - txb.

11. A vehicle structure comprising the integrally molded article according to any one of claims 1 to 10.

12. A component of a battery box comprising the integrally molded article according to any one of claims 1 to 10, wherein the component of the battery box is placed at a lower portion of a vehicle body.

13. A method for producing the integrally molded article according to any one of claims 1 to 10, comprising:

stacking the fiber-reinforced resin containing the reinforcing fibers and the first matrix resin and the shielding layer precursor; and
performing press-molding with an upper mold and a lower mold.

14. The method for producing the integrally molded article according to claim 13,
wherein the fiber-reinforced resin and the shielding layer precursor are laminated in such a manner that the fiber-reinforced resin is in contact with a lower mold, and the laminate is placed in the lower mold and subjected to the press-molding.

15. The method for producing the integrally molded article according to any one of claims 13 and 14,
wherein the relationship between a ductility E1 of the fiber-reinforced resin and a ductility E2 of the laminate of the fiber-reinforced resin and the shielding layer precursor satisfies $0.9 < E1/E2 < 50$.

16. The method for producing the integrally molded article according to any one of claims 13 to 15, wherein the first matrix resin and the second matrix resin are thermoplastic resins.

# FIG. 1

1

10

tx    ty

30    40

20

# FIG. 2A

1 1 0 3

1 1 0 2

1 1 0 4

## FIG. 2B

## FIG. 3

FIG. 4

## FIG. 5A

y-axis: [dB] (0, 10, 20, 30, 40, 50, 60, 70, 80, 90, 100, 110, 120, 130)
x-axis: [Hz] (1.00E+05, 1.00E+06, 1.00E+07, 1.00E+08, 1.00E+09)

## FIG. 5B

y-axis: [dB] (0, 10, 20, 30, 40, 50, 60, 70, 80, 90, 100, 110, 120, 130)
x-axis: [Hz] (1.00E+05, 1.00E+06, 1.00E+07, 1.00E+08, 1.00E+09)

## FIG. 5C

## FIG. 5D

# FIG. 5E

# FIG. 5F

FIG. 6

502

501

503

## FIG. 7

VIII →

601

603

601

VIII →

## FIG. 8

604

601

IX

603

601

605

# FIG. 9

604

603

605

# FIG. 10

XI →

701

703

701

XI →

FIG. 11

704

701

XII

703

705

701

FIG. 12

704

703

705

## FIG. 13

1A

20A

50

tb | txb

30  40

60

ta

txa

10A

## FIG. 14

102

101

103

104

105

106

Z

Y

X

107

**FIG. 15**

105

201

205

204

XVI

XVI

301

303

Z

Y

X

203

**FIG. 16**

Z

Y

X

301

205

204

303

313

## FIG. 17A

## FIG. 17B

## FIG. 17C

## INTERNATIONAL SEARCH REPORT

| International application No. |
| --- |
| **PCT/JP2024/017434** |

**A. CLASSIFICATION OF SUBJECT MATTER**

*H05K 9/00*(2006.01)i; *B29C 43/18*(2006.01)i; *B32B 5/28*(2006.01)i; *H01M 50/224*(2021.01)i; *H01M 50/231*(2021.01)i; *H01M 50/249*(2021.01)i

FI: H05K9/00 W; B29C43/18; B32B5/28 Z; H01M50/249; H01M50/224; H01M50/231

According to International Patent Classification (IPC) or to both national classification and IPC

**B. FIELDS SEARCHED**

Minimum documentation searched (classification system followed by classification symbols)

H05K9/00; B29C43/18; B32B5/28; H01M50/224; H01M50/231; H01M50/249

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | JP 6625435 B2 (FUJIKURA KASEI CO., LTD.) 06 December 2019 (2019-12-06) | 1-16 |
| A | JP 2012-109452 A (MITSUBISHI PLASTICS, INC.) 07 June 2012 (2012-06-07) | 1-16 |
| A | JP 59-102937 A (TOYO ALUMINIUM KK) 14 June 1984 (1984-06-14) | 1-16 |
| A | JP 58-212199 A (TOYO ALUMINIUM KK) 09 December 1983 (1983-12-09) | 1-16 |
| A | JP 59-98841 A (ALLIED CORPORATION) 07 June 1984 (1984-06-07) | 1-16 |
| E, A | JP 2024-68539 A (ASAHI KASEI KABUSHIKI KAISHA) 20 May 2024 (2024-05-20) | 1-16 |

☐ Further documents are listed in the continuation of Box C.    ☑ See patent family annex.

| | |
| --- | --- |
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | "&" document member of the same patent family |
| "P" document published prior to the international filing date but later than the priority date claimed | |

| Date of the actual completion of the international search | Date of mailing of the international search report |
| --- | --- |
| **16 July 2024** | **30 July 2024** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (July 2022)

## INTERNATIONAL SEARCH REPORT
### Information on patent family members

International application No.

**PCT/JP2024/017434**

| Patent document cited in search report | | | Publication date (day/month/year) | Patent family member(s) | | | Publication date (day/month/year) |
|---|---|---|---|---|---|---|---|
| JP | 6625435 | B2 | 06 December 2019 | (Family: none) | | | |
| JP | 2012-109452 | A | 07 June 2012 | (Family: none) | | | |
| JP | 59-102937 | A | 14 June 1984 | (Family: none) | | | |
| JP | 58-212199 | A | 09 December 1983 | (Family: none) | | | |
| JP | 59-98841 | A | 07 June 1984 | US | 4678699 | A | |
| | | | | EP | 109505 | A2 | |
| | | | | CA | 1232186 | A | |
| JP | 2024-68539 | A | 20 May 2024 | (Family: none) | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP S5884856 A
- JP H04110278 A
- WO 2021125386 A
- JP H09292480 A
- JP H06021683 A
- JP 2012109454 A
- US 8946342 B